**Europäisches Patentamt**

**European Patent Office**

**Office européen des brevets**

(19)

(11) Veröffentlichungsnummer : **0 007 099**
**B1**

(12) # EUROPÄISCHE PATENTSCHRIFT

(45) Veröffentlichungstag der Patentschrift :
30.03.83

(51) Int. Cl.³ : **H 01 L 29/10, H 01 L 29/743**

(21) Anmeldenummer : **79102405.2**

(22) Anmeldetag : **12.07.79**

(54) **Thyristor mit Amplifying Gate und Verfahren zur Herstellung.**

(30) Priorität : **13.07.78 DE 2830735**

(43) Veröffentlichungstag der Anmeldung :
**23.01.80 Patentblatt 80/02**

(45) Bekanntmachung des Hinweises auf die Patenterteilung : **30.03.83 Patentblatt 83/13**

(84) Benannte Vertragsstaaten :
**BE FR GB IT SE**

(56) Entgegenhaltungen :
**EP A 0 002 840**
**FR A 2 198 265**
**FR A 2 207 363**
**US A 3 337 782**
**IEEE TRANSACTIONS ON ELECTRON DEVICES, Vol. ED-23, Nr. 8, New York, US, K. HARTMANN : « Improvement of thyristor turn-on by calculation of the gate-cathode characteristic before injection », Seiten 912-917**
**TECHNICAL DIGEST OF THE 1974 INTERNATIONAL ELECTRON DEVICES MEETING, 9-11 Dezember 1974, New York, US, R.A. KOKOSA et al. : « Design criteria for amplifying gates on triode thyristors », Seiten 431-434**

(73) Patentinhaber : **Licentia Patent-Verwaltungs-GmbH**
**Theodor-Stern-Kai 1**
**D-6000 Frankfurt/Main 70 (DE)**

(72) Erfinder : **Pikorz, Wolfgang**
**Ahornweg 8**
**D-4788 Warstein 2 (DE)**
Erfinder : **Sommer, Karl Heinz, Dr.**
**Goethestrasse 12**
**D-4788 Warstein 2 (DE)**
Erfinder : **Sonntag, Alois, Dipl.-Phys.**
**Külbe 25**
**D-4788 Warstein 2 (DE)**

(74) Vertreter : **Lertes, Kurt, Dr.**
**Licentia Patent-Verwaltungs-GmbH Theodor-Stern-Kai 1**
**D-6000 Frankfurt/M 70 (DE)**

# Thyristor mit Amplifying Gate und Verfahren zur Herstellung

Die Erfindung betrifft einen Thyristor mit Amplifying Gate mit einem Halbleiterkörper aus Silizium, der an der kathodenseitigen Hauptfläche $n^+$-leitende Haupt- und Hilfsemitter mit Haupt- und Hilfselektrode und eine Steuerelektrode sowie zwischen dem Hilfsemitter (1) und dem Hauptemitter (2) in einem an der Hauptfläche des Halbleiterkörpers angrenzenden Bereich der p-Basis-Zone (6) eine $p^+$-Zone (3) aufweist. Die Erfindung betrifft weiter ein Verfahren zur Herstellung dieses Thyristors.

Thyristoren mit innerer Zündverstärkung, üblicherweise als Thyristoren mit « Amplifying Gate » bezeichnet, werden an Stelle von erheblich aufwendigeren Zündimpulsgeneratoren verwendet, um bei Leistungsthyristoren die Zündung mit möglichst hohem Steuerstrom vorzunehmen.

Bei Thyristoren mit Amplifying Gate ist in den Halbleiterkörper ein Hilfsthyristor integriert, der zuerst mit einem geringen Steuerstrom gezündet wird. Der Laststrom des Hilfsthyristors, der dem Lastkreis und nicht dem Steuerkreis entnommen wird, wirkt danach als hoher Steuerstrom für die Zündung des Hauptthyristors. Dieser übernimmt innerhalb kurzer Zeit den Laststrom des Hilfsthyristors und schützt ihn vor Zerstörung durch Überlastung.

Durch die Übersteuerung wächst die primär aufgezündete Kathodenfläche des Hauptthyristors, die verhältnismäßig groß dimensioniert werden kann. Daher verringert sich die Einschaltverlustleistung des Thyristors, und die zulässig Stromsteilheit $(di/dt)_{krit}$ wird gegenüber einem üblichen Thyristor ohne eine Struktur mit innerer Zündverstärkung erhöht.

Bei der Ausbildung von Thyristoren mit Amplifying Gate muß durch geeignete Maßnahmen sichergestellt werden, daß der Hilfsthyristor in jedem Fall vor dem Hauptthyristor zündet. Erfolgt dies nicht, so wird der Hauptthyristor zündet. Erfolgt dies nicht, so wird der Hauptthyristor zu schwach angesteuert, zündet ungleichmäßig an kleinen Flächenbereichen auf und kann durch thermische Überlastung der gezündeten Kanäle zerstört werden.

Nur bei richtiger Dimensionierung des Hilfsthyristorsystems kann ein dafür zulässiger Laststrom das Hauptthyristorsystem genügend übersteuern und gleichmäßiges Zünden bewirken. Der im Halbleiterkörper dem Hilfsemitter gegenüberliegende Randbereich des Hauptemitters kann daher, ohne daß ein hoher Steuerstrom von außen eingeprägt werden muß, damit der gesamte Randbereich des Hauptemitters gleichmäßig aufgezündet wird, verhältnismäßig groß dimensioniert werden.

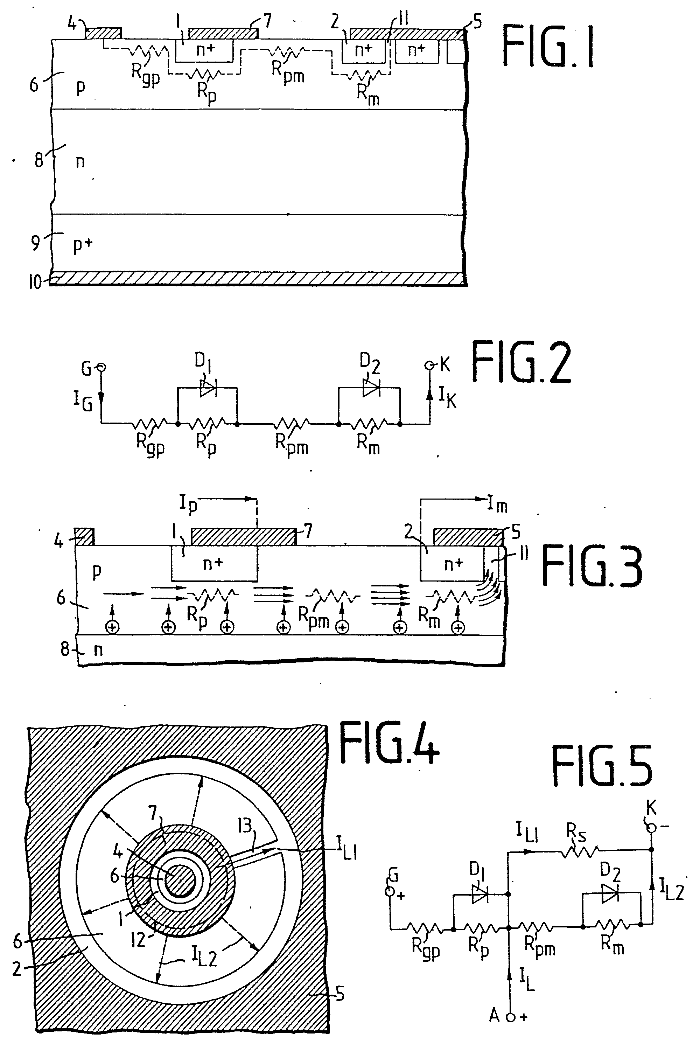

In der Literatur sind verschiedene Lösungen dieses Problems veröffentlicht worden. Die Kriterien für die Dimensionierung eines Thyristors mit Amplifying Gate wurden von R. A. Kokosa und E. D. Wolley, IEEE Intern. Electric Dev. Meeting 1974, Seiten 431 bis 434, angegeben. Ein bekannter typischer Thyristor mit Amplifying Gate ist in der Figur 1 dargestellt. Bei diesem befinden sich auf Halbleiterzonen 6, 8, 9 abwechselnden Leitungstyps (p, n, $p^+$) und einem metallischen Anodenkontakt 10 eine Steuerelektrode 4, ein metallischer Kontakt 7 des Hilfsemitters 1 sowie ein metallischer Kathodenkontakt 5 des Hauptemitters 2. Der Hauptemitter 2 weist einige Shortungslöcher 11 auf. Für die Funktion des Amplifying Gate sind die Schicht-Widerstände der Steuerbasiszone 6 zwischen Steuerelektrode 4 und Hilfsemitter 1, $R_{gp}$, unter dem Hilfsemitter 1, $R_p$, zwischen Hilfsemitter 1 und Hauptemitter 2, $R_{pm}$, und unter dem Rand, des Hauptemitters 2 und dem ersten Shortungsloch 11, $R_m$, maßgebend. Diese Widerstände sind in der Figur 1 gestrichelt eingezeichnet. Ein Ersatzschaltbild für einen solchen Thyristor ist in Figur 2 nach den Angaben von Victor A. K. Temple und Armand P. Ferro, IEEE Trans. Electr. Dev., Vol. ed-23, n° 8. August 1976, 893, dargestellt, wobei die Steuerelektrode mit G und die Kathode mit K bezeichnet sind.

Im Zustand vor dem Aufschalten ($I_A \approx 0$ ; $I_G = I_K$) fließt der Steuerstrom $I_G$ lateral durch die Widerstände der p-leitenden Steuerbasiszone 6. Er verursacht einen Spannungsabfall $V_p$ am Widerstand $R_p$ und einen Spannungsabfall $V_m$ am lateralen Basiswiderstand $R_m$. Erreichen $V_p$ oder $V_m$ den Wert von etwa 0,7 V bei Zimmertemperatur und den üblichen Dotierungsverhältnissen, so zündet dasjenige Thyristorsystem, an dem zuerst 0,7 V anliegen. Ein Amplifying Gate ist folglich denn richtig ausgelegt, wenn immer

$$V_p > V_m$$

ist.

Die bekannten Lösungen gehen nun davon aus, daß man diese Bedingung durch entsprechende Einstellung von $R_p$ und $R_m$ sicherstellt, d. h. man wählt die geometrischen Abmessungen so, daß

$$R_p > R_m$$

ist.

$R_p$ kann durch eine größere laterale Ausdehnung des Hilfsemitters 1 erhöht werden. Es könnte auch die $n^+$-Zone des Hilfsemitters 1 tiefer eindiffundiert werden und dadurch die Leitfähigkeit der p-Zone unterhalb von diesem $n^+$-Gebiet verschlechtert werden. Eine weitere bekannte Maßnahme, die auf eine Verkleinerung von $R_m$ hinausläuft, besteht darin, daß die ersten Shortungslöcher 11 im $n^+$-Gebiet des Hauptemitters 2 sehr nah an den dem Hilfsemitter 1 zugewandten Rand des Hauptemitters 2 gelegt werden und die Shortungslöcher einen verhältnismäßig großen Durchmesser erhalten.

Allen bekannten Maßnahmen, einen höheren Spannungsabfall unter dem Hilfsemitter 1 als unter dem Hauptemitter 2 zu erhalten, haben Nachteile in Bezug auf die dynamischen Eigenschaften der Thyristoren, die « kritische » Spannungsanstiegsgeschwindigkeit $(du/dt)_{krit}$ die « kritische » Stromanstiegsgeschwindigkeit $(di/dt)_{krit}$ und die Freiwerdezeit $t_q$.

Wird beispielsweise die laterale Ausdehnung des Hilfsemitters 1 vergrößert, so wird bei unverändertem Abstand zwischen Hauptemitterrand und erstem Shortungsloch im Hauptemitter 1 der Widerstand $R_p$ gegenüber dem Widerstand $R_m$ vergrößert. Dies hat zwar zur Folge, daß das Hilfsthyristorsystem zündet, doch ergeben sich Nachteile, die anhand der Figur 3 erläutert werden. Die Bezugszeichen der Figur 3 entsprechen denen der Figur 1. Beim Anlagen einer Spannung an den mittleren pn-Übergang zwischen den Schichten 6 und 8 fließt ein homogener Verschiebungsstrom von Defektelektronen vertikal aus der sich aufbauenden Raumladungszone zum $n^+$-Emitter. Die Stromdichte dieses Löcherstromes ist auf der gesamten Fläche des pn-Überganges konstant. Der Betrag des Löcherstromes wird von der Spannungssteilheit du/dt bestimmt.

Es entspricht dem Stande der Technik, daß man die Shortungsdichte im Hauptemitter 2 so wählt, daß bei der gewünschten Spannungssteilheit alle unter dem Bereich des Hauptemitters 2 fließenden Löcher über die Shortungslöcher oder Kanäle 11 abgeleitet werden, ohne eine Injektion von Elektronen aus dem Hauptemitter 2 hervorzurufen.

In dem Gebiet des Thyristors, das nicht unter dem geshorteten Hauptemitter 2 liegt, fließt der Defektelektronenstrom vertikal mit gleicher Stromdichte aus der sich aufbauenden Raumladungszone heraus wie unter dem Hauptemitter. Im Gegensatz zu den Verhältnissen unter dem Hauptemitter können in diesem Bereich die Löcher aber nicht über Shortungskanäle abfließen, da der Hilfsemitter 1 nicht an die äußere Spannungsquelle angeschlossen ist. Der gesamte Löcherstrom aus diesem Gebiet muß lateral durch die Steuerbasiszone 6 zu den ersten Shortungskanälen 11 des Hauptemitters 2 abfließen. Die laterale Stromdichte wächst dabei vom Steuerkontakt 4 zum Hauptemitter 2 kontinuierlich an, was in der Figur 3 durch Vergrößerung der Zahl von die Stromdichte symbolisierenden Pfeile dargestellt ist. Der bis zum äußeren Rand des Hilfsemitters aufsummierte Strom ist mit $I_p$, der unter den Hauptemitter eintretende Strom mit $I_m$ bezeichnet.

Eine große laterale Ausdehnung des Hilfsemitters 1 hat immer einen großen lateralen Löcherstrom zur Folge. Es kommt daher bei höherer Spannungssteilheit du/dt oder Belastung durch Unterschreiten der Freiwerdezeit $t_q$ schnell zum Überschreiten der « kritischen » Spannung von 0,7 V durch die Spannungsabfälle $I_p \cdot R_p$ an $R_p$ bzw. $I_m \cdot R_m$ an $R_m$, d.h. der Thyristor schaltet ohne Einspeisung eines Steuerstromes als Folge des lateralen Löcherstromes ein.

Ähnliche Nachteile insbesondere im Sperrverhalten des Thyristors ergeben sich, wenn die Vergrößerung von $R_p$ durch eine größere Tiefe des Hilfsemitters 1 eingestellt wird, d. h. also wenn etwa die $n^+$-Zone des Hilfsemitters 1 tiefer in die Steuerbasiszone 6 eindiffundiert wird und dadurch die Leitfähigkeit dieser p-Zone 6 unterhalb dieses $n^+$-Gebietes verringert wird. Ein solcher Thyristor wird zwar immer am Hilfsemitter 1 zuerst zünden, besitzt aber bei fleicher Länge des Hauptemitterinnenrandes, die durch das geforderte di/dt festgelegt ist, keine besseren du/dt und $t_q$-Werte als der Thyristor mit lateral ausgedehntem Hilfsemitter. Das Produkt $I_m \cdot R_m$ wird durch die beschriebene Maßnahme nicht verändert, d. h. der Thyristor zündet bei gleichen Werten des lateralen Löcherstromes $I_m$ wie der zuvor betrachtete Thyristor mit lateral ausgedehntem Hilfsemitter.

Statt den Widerstand $R_p$ im Bereich unterhalb des Hilfsemitters 1 zu erhöhen, sind auch Maßnahmen bekannt geworden, den Widerstand $R_m$ im Bereich des Hauptemitters 2 zu verkleinern. Dies wird dadurch erreicht, daß die ersten Shortungskanäle 11 im $n^+$-Gebiet des hauptthyristors 2 sehr nahe an den dem Hilfsemitter 1 gegenüberliegenden Rand gelegt werden und die Shortungskanäle eine große Fläche erhalten. Solche Maßnahmen, die auf einer verstärkten Shortung des Hauptemitters 2 beruhen, besitzen jedoch den Nachteil, daß die Ausbreitungsgeschwindigkeit des Einschaltvorganges verringert wird, da nur ein Teil des Randes des Hauptemitters 2 zu Beginn des Einschaltvorganges Strom führt, was größere Einschaltverluste verursacht.

Schließlich sind noch diffundierte ohmsche Verbindungen in Form von streifenförmigen Strompfaden oder Stegen zwischen Hilfs- und Hauptemitter, wie etwa in der DE-OS 23 29 872 beschrieben, bekanntgeworden. Hierbei handelt es sich um einen an der Oberfläche des Halbleiterkörpers liegenden ohmschen Strompfad, der nicht durch einen pn-Übergang unterbrochen ist. Bei $n^+$-Emittern kann dieser Steg daher nur als n-leitendes Gebiet ausgebildet sein. Der Steg hat die Wirkung eines Festwiderstandes, der Hilfs- und Hauptemitter miteinander verbindet. In Fig. 4 ist eine Ausführung mit Steg 13 in einer Draufsicht dargestellt. Die Bezugszeichen entsprechen denen der Fig. 1 Der unter dem Hilfsmitterkontakt 7 liegende $pn^+$-Übergang zwischen der Steuerbasiszone 6 und dem Hilfsemitter 1 hat das Bezugszeichen 12. Über den Steg 13 fließt der Laststrom $I_{L1}$, durch das p-leitende Gebiet 6 fließt der Laststrom $I_{L2}$. Die Lastströme $I_{L1}$ und $I_{L2}$ sind die jeweiligen Anteile des Gesamtlaststromes $I_L$.

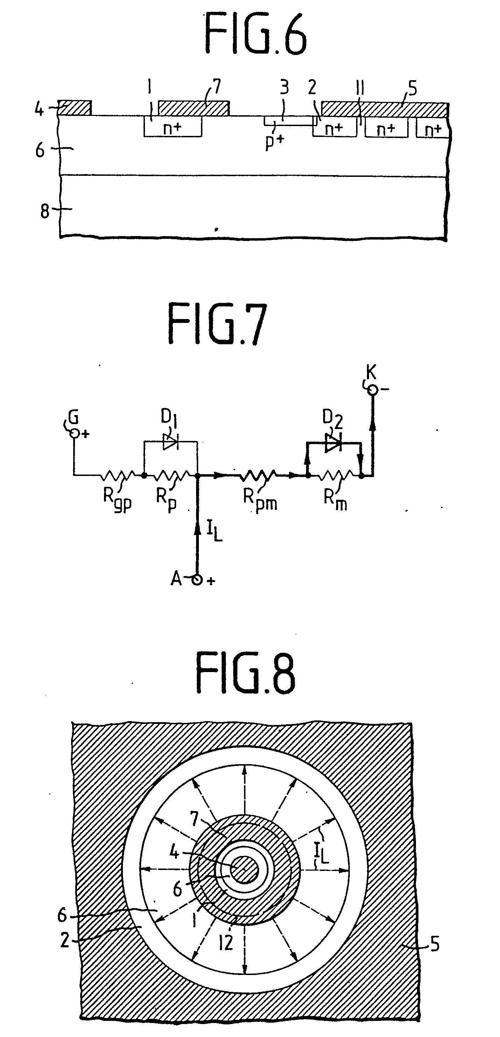

Die Wirkungsweise des n-Steges sei an Hand eines Ersatzschaltbildes in Fig. 5 näher erläutert. Die Widerstände $R_p$, $R_m$ und $R_s$ seien so gewählt, daß das Hilfsthyristorsystem immer vor dem Hauptthyristorsystem zündet. Der Laststrom $I_L$ des Hilfsthyristorsystems, der durch den von der Anode A ausgehenden Pfeil angedeutet ist, ruft die Zündung des Hauptthyristors hervor.

Mit $R_s$ ist der Widerstand des Steges mit n-

Leitfähigkeit bezeichnet, $R_{pm}$ und $R_m$ haben die oben beschriebene Bedeutung. Der im Hilfsthyristorsystem fließende Laststrom $I_L$ teilt sich somit in die beiden Anteile $I_{L1}$ und $I_{L2}$ entsprechend den Widerstandsverhältnissen $R_s$ und $R_{pm} + R_m$ in Parallelschaltung auf. Der Anteil $I_{L1}$ fließt, ohne die Wirkung eines Steuerstromes für das Hauptthyristorsystem zu haben, über den Steg vom Hilfs- zum Hauptthyristorsystem ab. Nur der Anteil $I_{L2}$ bewirkt bei genügender Größe das Zünden des Hauptthyristorsystems.

Um gute du/dt- und $t_q$-Eigenschaften des Thyristor, d. h. eine große zulässige Steilheit oder Anstiegsgeschwindigkeit $(du/dt)_{krit}$ der am Thyristor von der Rückwärts- in die Vorwärtsrichtung wechselnden Spannung und eine kurze Freiwerdezeit $t_q$ zu erreichen, muß $R_s$ klein gegenüber $R_m + R_{pm}$ gewählt werden, damit ein genügend großer Teil des aus dem nicht unter dem Hauptemitter liegenden Gebiet anfallenden kapazitiven Löcherstromes über $R_s$ abfließen kann, ohne eine Injektion am Hauptemitter hervorzurufen.

Ein kleiner $R_s$-Wert führt zu folgenden generellen Nachteilen : Beim Zünden mit einem Steuerstrom muß das Hilfsthyristorsystem einen entsprechend höheren Laststrom führen, bevor das Hauptthyristorsystem zündet. Der zündunwirksame Anteil $I_{L1}$ wird vergrößert und bewirkt eine unerwünschte Erwärmung des Hilfsthyristorsystems. Bei höheren Frequenzen kann dies zur Überlastung und zur thermischen Zerstörung des Hilfsthyristorsystems führen.

Nimmt man diesen generellen Nachteil in Kauf, so bleiben darüber hinaus je nach geometrischer Ausführung weitere Verschlechterungen bezüglich der di/dt- oder du/dt-Eigenschaften des ganzen Thyristors bestehen. Um ein kleines $R_s$ zu erreichen, kann man entweder einen oder wenige breite Stege oder viele schmale Stege anbringen. Ein breiter Steg würde die du/dt-Eigenschaft verschlechtern, da der Steg wie ein nicht geshorteter $n^+$-Emitter wirkt. bei vielen schmalen Stegen würde dagegen das Hauptthyristorsystem an dem dem Hilfsemitter gegenüberliegenden Innenrand nur jeweils zwischen den Stegen zünden, wodurch die di/dt-Eigenschaft verschlechtert wird, d. h. es wird der zulässige Anstieg $(di/dt)_{krit}$ des Durchlaßstromes (zulässige Stromsteilheit) geringer. Die Stege wirken sich mirhin ähnlich wie Shortungslöcher am Hauptemitterinnenrand aus.

Der Erfindung liegt die Aufgabe zugrunde, einen Thyristor mit Amplifying Gate zu schaffen und dafür ein Herstellungsverfahren anzugeben, der sich durch kurze Freiwerdezeit, niedrige Einschaltverluste sowie durch hohe zulässige Strom- und Spannungsanstiegsgeschwindigkeit $((di/dt)_{krit}, (du/dt)_{krit})$ auszeichnet, bei dem der Hilfsthyristor immer vor dem Hauptthyristor zündet, und welcher Thyristor die oben angegebenen Nachteile, die sich bei Anwendung bekannter Lösungsvorschläge, nämlich lateral größere Hilfsemitter, Shortungslöcher dicht am Rand des Hauptemitters, stromleitende Stege zwischen Hilfs- und Hauptemitter ergeben, nicht aufweist.

Diese Aufgabe wird bei einem Thyristor mit Amplifying Gate und mit den eingangs wie auch im Oberbegriff des Anspruchs 1 angegebenen Merkmalen erfindungsgemäß dadurch gelöst, daß die Tiefenerstreckung der $p^+$-Zone in der p-Basiszone kleiner als die der Zone des Hauptemitters ist und die den dem Hilfsemitter zugewandten Randbereich des Hauptemitters zumindest berührt oder in ihn hineinragt und mit ihm einen $p^+n^+$-Übergang bildet.

Bei einer zweckmäßigen Ausführungsform ist vorgesehen, daß die $p^+$-Zone den gesamten, dem Hilfsemitter zugewandten Randbereich des Hauptemitters entweder berührt oder in ihn hineinragt und mit ihm einen $p^+n^+$-Übergang bildet.

Besonders vorteilhaft ist es, wenn sich die $p^+$-Zone 30 % weit von der Tiefe des $pn^+$-Übergangs des Hauptemitters und der Steuerbasiszone in dieselbe erstreckt und mindestens 0,1 μm in die Hauptemitterzone eindringt. Andererseits kann sich die $p^+$-Zone bis unterhalb der Elektrode des Hilfsemitters erstrecken. Die Konzentration der Störstellen in der $p^+$-Zone wird zweckmäßig mindestens eine Größenordnung höher als in der p-Basiszone und höchstens eine Größenordnung niedriger als in der Zone des $n^+$-leitenden Hauptemitters eingestellt. Wird eine Dotierung der p-Steuerbasiszone mit Gallium gewählt, dann kommt für die $p^+$-Zone Bor als Störstellenmaterial in Betracht.

Um einen Thyristor gemäß der Erfindung mit Amplifying Gate nach einem Verfahren herzustellen, nach welchem zuerst in einem Halbleiterkörper aus Silizium die Zonenstruktur eines Thyristors in bekannter Weise ausgebildet worden ist, wird bei dem mit der Zonenstruktur eines Thyristors ausgebildeten Halbleiterkörper das dem Hilfsemitter zugewandte Randgebiet des Hauptemitters mit einer Diffusionsmaske maskiert und alsdann ein Akzeptorelement so lange in den Halbleiterkörper eindiffundiert, bis die Störstellenkonzentration in der sich bildenden $p^+$-Zone höchstens eine Größenordnung geringer als die Konzentration der Donatoren in der $n^+$-Zone ist und ein $p^+n^+$-Übergang mit dem Hauptemitter gebildet ist.

Mit der Erfindung wird erreicht, daß im Überlappungsgebiet am Zonenübergang ein $p^+n^+$-Übergang entsteht. Die $n^+$-Zone, die beispielsweise mit Phosphor in einer Konzentration von $N_D = 10^{21}$ Atome $\times$ cm$^{-3}$ dotiert ist, bleibt auch im Überlappungsgebiet $n^+$-leitend, die bereits mit Gallium dotierte p-Zone wird durch die nachträgliche Bordiffusion mit $N_A = 10^{20}$ Atome $\times$ cm$^{-3}$ im vorgesehenen Bereich des Hauptemitterrandes in eine $p^+$-Schicht vorgegebener Tiefe umgewandelt. Der $p^+n^+$-Übergang am Rand des Hauptemitters, d. h. ein Übergang zwischen Halbleiterzonen, in denen Entartung vorliegt, zeigt ein vom $pn^+$-Übergang am Rand des Hilfsemitters besonders in Flußrichtung völlig verschiedenes Verhalten.

In der vorangehenden beschreibung ist auf die Figuren 1 bis 5 der Zeichnung Bezug genommen.

Die Erfindung wird nun anhand der Figuren 6 bis 11 der Zeichnung nachstehend beispielhaft näher erläutert. Es zeigen

Figur 6 den Hauptteil der Zonenstruktur eines Thyristors gemäß der Erfindung als Querschnitt durch den Halbleiterkörper;

Figur 7 ein Ersatzschaltbild der Zonenstruktur nach Fig. 6;

Figur 8 einen Längsschnitt durch die Elektroden des Thyristors nach Fig. 6 mit Draufsicht auf eine Hauptfläche (Oberfläche) des Halbleiterkörpers;

Figur 9 Durchlaßkennlinien der Dioden $D_1$ und $D_2$ im Ersatzschaltbild nach Fig. 7;

Figuren 10 und 11 ganze Zonenstrukturen von zwei erfindungsgemäß ausgebildeten Thyristoren als Querschnitte durch deren Halbleiterkörper.

In der Fig. 6 entsprechen die Bezugszeichen denjenigen in den Figuren 1 und 3. An der Oberfläche der p-Steuerbasiszone 6 ist eine $p^+$-Zone 3 ausgebildet. Die Tiefe der $p^+$-Zone 3 soll 10 bis 100 %, vorzugsweise 30 % der Tiefe des $pn^+$-Übergangs des Hauptemitters ($n^+$-Zone 2) zur Steuerbasiszone, beispielsweise etwa 12 $\mu$m, betragen. Diese Zonen überlappen sich, um eine lückenlose Herstellung des $p^+n^+$-Übergangs zwischen der $p^+$-Zone 3 und der $n^+$-Zone 2 zu ermöglichen. Daher soll die $p^+$-Zone 3 mindestens 0,1 $\mu$m in die $n^+$-Zone 2 eindringen. Die $p^+$-Zone erstreckt sich möglichst weit in Richtung zum Hilfsemitter, wie es für die Ausbildung eines kleinen Widerstandswertes $R_{pm}$ nach Fig. 5 vorteilhaft ist. Kleine $R_{pm}$-Werte bewirken niedrige Zündspannungen. Durch Vorgabe der Tiefe der $p^+$-Zone 3 läßt sich erreichen, daß der Hauptthyristor bei genau vorgegebenem Laststrom des Hilfsthyristors zündet.

Bei einem Thyristor mit zentraler Steuerelektrode hat die $p^+$-Zone 3 eine kreisringförmige Gestalt. Die Konzentration der Störstellen in der $p^+$-Zone 3 soll mit $N_A > 10^{19}$ Atome $\times$ cm$^{-3}$ deutlich über der ursprünglichen p-Dotierung mit $N_A = 10^{18}$ Atome $\times$ cm$^{-3}$ liegen. Der Unterschied der Störstellenkonzentration in der $p^+$- und $n^+$-Zone darf höchstens einen Faktor 10 betragen. Ist z. B. die p-Zone 6 durch Eindiffusion von Gallium erzeugt und die $n^+$-Zone 2 durch Eindiffusion von Phosphor oder Arsen, dann ist es vorteilhaft, die $p^+$-Zone durch Eindiffusion von Bor zu erzeugen, um die gewünschte Störstellenkonzentration leicht einstellen zu können.

Die Wirkungsweise eines Thyristors gemäß der Erfindung wird anhand der Fig. 6 sowie des Ersatzschaltbildes nach Fig. 7 wie folgt erläutert. Es muß die Bedingung

$$V_p > V_m$$

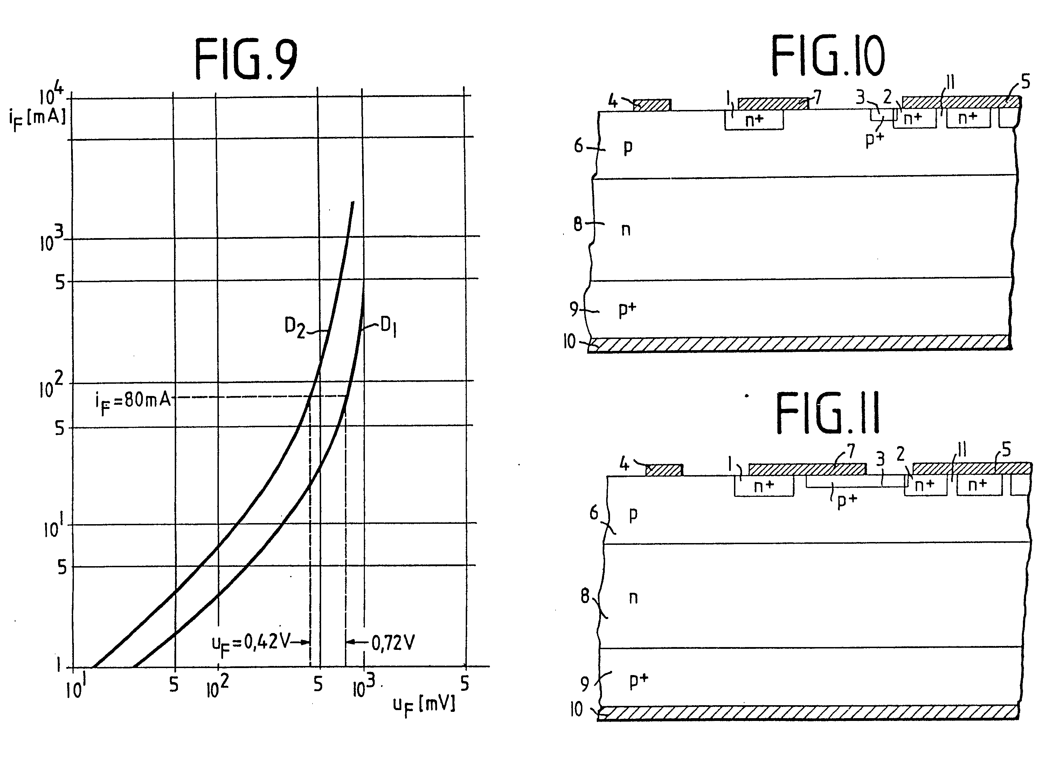

für die gewünschte Wirkung und Funktion des Amplifying Gate bei dem Thyristor erfüllt sein, nämlich daß der Hilfsthyristor immer vor dem Hauptthyristor zündet. Sie wird bei der gezeigten Anordnung nicht mit Hilfe der Widerstände $R_p$ und $R_m$ eingestellt, sondern durch eine gezielte Veränderung der Durchlaßkennlinie der Diode $D_2$ gegenüber der Diode $D_1$. Diese Diode $D_1$ wird durch den $pn^+$-Übergang zwischen der p-Steuerbasiszone 6 und dem $n^+$-Hilfsemitter 1 gebildet und hat somit normale Durchlaß- und Injektionseigenschaften (s. Fig. 9), insbesondere hat sie eine verhältnismäßig große Schleusenspannung von etwa 0,7 V, die durch die Dotierungsverhältnisse in der p- und der $n^+$-Zone gegeben wird.

Die Diode $D_2$ wird durch den $p^+n^+$-Übergang zwischen der hochdotierten Zone 3 und der Hauptemitterzone 2 gebildet. Die Dotierungskonzentration auf der $p^+$-Seite dieses Übergangs ist durch eine zusätzliche Diffusion gegenüber der Diode $D_1$ wesentlich angehoben. Die Diode $D_2$ besitzt daher eine deutlich geringere Schleusenspannung als die Diode $D_1$. Infolge der guten Durchlaßeigenschaften der Diode $D_2$ fließt der überwiegende Teil des Laststromes $I_L$ des Hilfsemitters über diese Diode $D_2$ und nicht über den Widerstand $R_m$ zur Kathode ab. Im Ersatzschaltbild der Fig. 7 ist der Fließweg des Laststromes durch die Strichstärke der Zeichnung hervorgehoben.

Der Laststrom $I_L$ teilt sich zwischen dem Metallkontakt der Elektrode 7 des Hilfsemitters und dem gegenüberliegenden Rand des Hauptemitters 2 nicht in zwei unterschiedliche Komponenten auf, wie es bei der Steganordnung nach Fig. 4 der Fall ist. Die Stromführung geht vielmehr, wie in Fig. 8 schematisch dargestellt, so vor sich, daß die Stromdichte längs der Peripherie des Metallkontaktes der Elektrode 7 des Hilfsemitters überall gleich groß ist. Dadurch wird eine lokale thermische Überlastung vermieden. In Fig. 9 sind Durchlaßkennlinien der Dioden $D_1$ und $D_2$ dargestellt, wie sie an einem Thyristor gemessen wurden, der nach dem Verfahren gemäß der Erfindung hergestellt wurde.

Beim Fließen eines Steuerstromes zwischen der Steuerelektrode 4 und dem Hauptemitter 2 entsteht am Widerstand $R_p$ eine Spannung $V_p$. Wird diese Spannung größer, also ungefähr 0,7 V, dann wird die Diode $D_1$ in Durchlaßrichtung gepolt und das Hilfsthyristorsystem gezündet. Die Zündung des Hauptthyristorsystems ist dabei noch sicher vermieden, da die $p^+n^+$-Diode $D_2$ noch nicht die kritische Spannung von 0,7 V erreicht hat. Wie dem Diagramm der Fig. 9 zu entnehmen ist, wird an der Diode $D_1$ der (kritische) Schwellenwert von 0,7 V erreicht oder überschritten, wenn der Durchlaßstrom $i_F = 80$ mA ist. Bei diesem Strom zündet also das Hilfsthyristorsystem. Die Spannung an der Diode $D_2$ beträgt bei dem gleichen Strom nur etwa 0,42 V. Das Hauptthyristorsystem kann daher noch nicht zünden. Mit zunehmendem Laststrom $I_L$ des Hilfsthyristors nimmt die Spannung an der Diode $D_2$ zu, und es zündet beim Erreichen von 0,7 V an der Diode $D_2$ auch das Hauptthyristorsystem und damit der ganze Thyristor. Dies geschieht entsprechend dem Beispiel, wenn der Laststrom größer als 1 000 mA wird.

Die Höhe des Laststromes $I_L$, der zum Erreichen von 0,7 V an der Diode $D_2$ fließen muß, hängt von den Dotierungskonzentrationen in den oben angegebenen $p^+$- und $n^+$-Zonen ab. Bei Annäherung der Akzeptorkonzentration in der $p^+$-Zone 6 an die Donatorkonzentration in der $n^+$-Zone 2 wird die Durchlaßspannung der Diode $D_2$ kleiner, d. h. es wird der zum Zünden des Hauptthyristorsystems erforderliche Strom $I_L$ des Hilfsthyristorsystems größer.

Da die Größe von $R_m$ nun keinen entscheidenden Einfluß mehr besitzt, kann man die Shortungslöcher oder Shortungskanäle 11 weiter vom Hauptemitterrand entfernt anbringen. Eine Behinderung der Zündausbreitung beim Zünden des Hauptthyristorsystems entfällt, und der gesamte Hauptemitterrand trägt sofort nach der Zündung zu der Stromführung bei. Hieraus resultieren eine höhere zulässige Stromanstiegsgeschwindigkeit $(di/dt)_{krit}$ und geringere Einschaltverluste.

Auf die Eigenschaften des Thyristors hinsichtlich der Höhe der zulässigen Spannungsanstiegsgeschwindigkeiten $(du/dt)_{krit}$ und der Freiwerdezeit $t_q$, die sich abhängig von der Ableitung des kapazitiven Löcherstromes aus dem nicht unter dem Hauptemitter liegenden Gebiet des Thyristors ergeben, wirkt sich die niedrige Durchlaßspannung der Diode $D_2$ ebenfalls besonders vorteilhaft aus. Es werden auch hohe kapazitive Löcherströme bis zu einigen Ampere Stromstärke über die Diode $D_2$ zur Kathode abgeleitet, ohne daß am Rande des Hauptemitters eine zum Zünden hinreichende Spannung in Höhe von 0,7 V entsteht. Die Ableitung des Löcherstromes aus dem nicht unter dem Hauptemitter liegenden Gebiet des Thyristors bewirkt, daß die Freiwerdezeit $t_q$ kürzer wird. Nach einer vorangegangenen Durchlaßbelastung sind die Basiszonen 6 und 8 mit Ladungsträgern gefüllt. Die Ladungsträgerkonzentration muß bekanntlich aber auf einen bestimmten Wert abgesunken sein, bevor der Thyristor wieder Spannung in Rückwärtsrichtung bei gegebenem Spannungsanstieg $du/dt$ sperren kann. Bei einer vorgegebenen Dichte der Shortungskanäle 11 des Haupt- und Hilfsemittersystems ist eine Restkonzentration an Ladungsträgern maximal noch zulässig, welche zusammen mit dem kapazitiven Löcherstrom bei in Durchlaßrichtung wiederkehrender Spannung gerade noch nicht ein Zünden des Thyristors unter den kurzgeschlossenen Emitterflächen bewirkt.

Ein im Gebiet des Steuerkontaktes und des Hilfsemitters auftretender kapazitiver Löcherstrom fließt stets zu dem dem Hilfsemitter gegenüberliegenden Rand des Hauptemitters, so daß sich hier eine überhöhte Löcherdichte ergibt. Sie würde trotz hinreichender « Shortung » der Emitter ein Zünden des Thyristors am Rand des Hauptemitters bewirken, was üblicherweise als ein Kippen durch Unterschreiten der Freiwerdezeit bezeichnet wird. Um das Kippen zu verhindern, kann man entweder die Restkonzentration der Ladungsträger weiterhin abnehmen lassen, was Zeit beansprucht, oder die Dichte der Shortungslöcher im Randgebiet des Hauptemitters erhöhen, was von Nachteil ist hinsichtlich der Stromanstiegsgeschwindigkeit $di/dt$ und der Einschaltverluste.

Bei einem, wie beschrieben, erfindungsgemäß ausgebildeten Thyristor wird das Kippen am Rand des Hauptemitters vermieden, da der kapazitive Löcherstrom über die Diode $D_2$ (Fig. 7) abfließt, ohne Injektion hervorzurufen.

Im folgenden wird noch auf die Figuren 10 und 11 Bezug genommen :

Fig. 10 zeigt eine Zonenstruktur mit Zonen 6, 8, 9 abwechselnden Leitungstyps (p, n, $p^+$) auf einer Elektrode 10 als Anode. Auf der Oberfläche der p-leitenden Zone 6 befinden sich eine Steuerelektrode 4, ein metallischer Kontakt 7 oder Elektrode des Hilfsemitters 1 (Hilfselektrode) sowie ein metallischer Kontakt 5 oder Elektrode des Hauptemitters 2 (Hauptelektrode) als Kathode. Der Hauptemitter 2 weist einige Shortungslöcher 11 auf. Erfindungsgemäß ist zwischen dem Hilfsemitter 1 und dem Hauptemitter 2 eine $p^+$-Zone 3 angeordnet, deren eines Randgebiet mit dem Hauptemitter 2 einen $p^+n^+$-Übergang bildet.

Die Ausdehnung der $p^+$-Schicht 3 in Richtung zum Hilfsemitter 1 ist im Grunde für die Wirkungsweise der $p^+n^+$-Diode unwesentlich. Die « vertikale » (zu den Hauptflächen des Halbleiterkörpers gerichtete) Ausdehnung der $p^+$-Zone 3 wird durch die Zeit und die Temperatur bei der $p^+$-Diffusion (z. B Bor) bestimmt. Mit zunehmender « vertikaler » Ausdehnung der $p^+$-Schicht 3 sinkt die Durchlaßspannung der $p^+n^+$-Diode, d. h. der zum Zünden des Hauptthyristorsystems erforderliche Laststrom $I_L$ des Hilfsthyristorsystems nimmt zu. Seine Obergrenze wird durch die Verlustleistung im Hilfsthyristorsystem gegeben. In der Praxis hat sich gezeigt, daß gute dynamische Eigenschaften $t_q$, $(du/dt)_{krit}$, $(di/dt)_{krit}$ erreicht werden, wenn der Hauptthyristor erst bei Strömen von 1 A bis 5 A gezündet wird, das Hilfsthyristorsystem hingegen bei Strömen zwischen 50 bis 100 mA. Somit hat ein Thyristor gemäß der Erfindung ein großes « Übersetzungsverhältnis » der Zündströme der beiden Systeme.

Nach einer weiteren Ausgestaltung der Erfindung, die in der Fig. 11 erläutert ist, erstreckt sich die hochdotierte $p^+$-Zone 3 von der $n^+$-Zone des Hauptemitters 2 bis unter die Elektrode 7 des Hilfsemitters 1. Derart mit einer $p^+n^+$-Diode und einer Brücke eines $p^+$-leitenden Gebietes 3 zwischen Hauptemitter 2 und Hilfsemitter 1 ausgebildet, weisen Thyristoren mit Amplifying Gate weitere Vorteile auf. Dadurch, daß sich die hochdotierte $p^+$-Zone 3 bis unter die Elektrode 7 des Hilfsemitters 1 erstreckt, wird der Widerstandswert von $R_{pm}$ sehr klein, so daß die Zündspannung nieder ist. Das hat besonders für die Parallelschaltung von derartigen Thyristoren Bedeutung.

Durch die Erfindung wird erreicht, daß unter Betriebsbedingungen, unabhängig von der gewählten Geometrie des Hilfs- und Hauptemitters (d. h. unabhängig von dem Verhältnis $R_m$ zu $R_p$) das Hilfsthyristorsystem stets vor dem Hauptthyristorsystem gezündet wird. Hinzu ergeben sich Verbesserungen der dynamischen Eigenschaften des Thyristors, nämlich höhere zulässige Strom- und Spannungsanstiegsgeschwindigkeit und kürzere Freiwerdezeit als bei Thyristoren des Standes der Technik. Thyristoren gemäß der Erfindung sind zur Anwendung als schnell schaltende elektronische Schalter für statische Umformer und Wechselrichter geschaffen, weil damit ein fortlaufendes betriebsmäßiges Schalten derart möglich ist, daß das Hilfsthyristorsystem stets vor dem Hauptthyristorsystem gezündet wird und dadurch ein genügend großer Zündstrom für den Hauptthyristor verfügbar ist.

Zur Herstellung eines Thyristors mit Amplifying Gate gemäß der Erfindung wird das folgende Verfahren angewandt : Als Material des Halbleiterkörpers wird Silizium vom n-Leitungstyp verwendet, beispielsweise mit Phosphor dotierte Siliziumscheiben, die einen Durchmesser von 10 ... 80 mm und eine Scheibendicke von 300 ... 800 $\mu$m aufweisen, die dem jeweils gewünschten Sperrvermögen des Thyristors anzupassen ist. Die Höhe der Grunddotierung mit Donatoren beträgt etwa $1 \times 10^{13} ... 1 \times 10^{14}$ Atome $\times$ cm$^{-3}$. Die Siliziumscheiben werden zunächst während einer Zeit von 20 ... 35 Stunden bei einer Temperatur von etwa 1 250 °C einer beidseitigen Gallium-Diffusion unterzogen, wobei das Gallium etwa 45 ... 70 $\mu$m in die Siliziumscheiben eindringt und eine Konzentration von $(2 ... 6) \times 10^{18}$ Atome $\times$ cm$^{-3}$ einnimmt. Während einer Dauer von 2 bis 7 Stunden werden die Siliziumscheiben bei 1 220 °C durch eine Behandlung mit feuchtem Sauerstoff mit einer Oxidschicht überzogen, auf der mit Hilfe von photolithographischen oder Siebdruckverfahren die Zonenstruktur des Thyristors erzeugt wird. Dann werden Maskenöffnungen in der Oxidschicht gebildet, und durch die so gebildete Diffusionsmaske wird während einer Zeit von 5 ... 10 Stunden bei einer Temperatur von etwa 1 260 °C Phosphor zur Bildung des Haupt- und des Hilfsemitters eindiffundiert, dessen Konzentration dann etwa $10^{21}$ Atome $\times$ cm$^{-3}$ in den Emitterbereichen beträgt. Der Phosphor dringt — als Haupt- und als Hilfsemitter — 15 bis 30 $\mu$m tief in die Siliziumscheiben ein.

Die Siliziumscheiben werden nun erfindungsgemäß in einer feuchten Sauerstoffatmosphäre während einer Zeit von etwa 2 Stunden bei 1 220 °C mit einer zweiten Oxidschicht überzogen, in der ebenfalls, wie oben erwähnt, Maskenöffnungen für eine Akzeptor-Diffusion gebildet werden. Als Akzeptorstoff wird vorzugsweise Bor angewendet, das bei einer Temperatur von 1 250 °C während einer Zeit von 2 ... 8 h etwa 8 ... 20 $\mu$m tief in die Siliziumscheiben eindringt. Da sich die Konzentrationen der p$^+$ und n$^+$-Zonen um weniger als eine Größenordnung voneinander unterscheiden sollen, muß, wenn die Phosphorkonzentration etwa $10^{21}$ Atome $\times$ cm$^{-3}$ beträgt, die Bordiffusion eine Konzentration wenig größer als $10^{20}$ Atome $\times$ cm$^{-3}$ ergeben, damit der zu bildende p$^+$n$^+$-Übergang die angestrebten Eigenschaften erhält, die oben ausführlich erörtert sind. Die weiteren Verfahrensschritte, nämlich Entfernung der Oxidschicht, die Metallisierung der Haupt- und der Hilfselektrode durch Aufdampfen von Gold im Hochvakuum, ferner Auflegieren der Siliziumscheibe an der Anode auf einer Tragscheibe aus Molybdän mittels einer Zwischenschicht aus Aluminium, dann Randbearbeitung und die Passivierung sowie schließlich Einbau der Siliziumscheibe in ein Gehäuse werden in bekannter Weise vorgenommen.

## Ansprüche

1. Thyristor mit Amplifying Gate mit einem Halbleiterkörper aus Silizium, der an der kathodenseitigen Hauptfläche n$^+$-leitende Haupt- und Hilfsemitter mit Haupt- und Hilfselektrode und eine Steuerelektrode sowie zwischen dem Hilfsemitter (1) und dem Hauptemitter (2) in einem an der Hauptfläche des Halbleiterkörpers angrenzenden Bereich der p-Basis-Zone (6) eine p$^+$-Zone (3) aufweist dadurch gekennzeichnet, daß die Tiefenerstreckung der p$^+$-Zone (3) in der p-Basiszone kleiner als die der Zone des Hauptemitters (2) ist und die den dem Hilfsemitter (1) zugewandten Randbereich des Hauptemitters (2) zumindest berührt oder in ihn hineinragt und mit ihm einen p$^+$n$^+$-Übergang bildet.

2. Thyristor mit Amplifying Gate nach Anspruch 1, dadurch gekennzeichnet, daß die p$^+$-Zone (3) den gesamten, dem Hilfsemitter (1) zugewandten Randbereich des Hauptemitters (2) entweder berührt oder in ihn hineinragt und mit ihm einen p$^+$n$^+$-Übergang bildet.

3. Thyristor nach Anspruch 1 oder 2, dadurch gekennzeichnet, daß die Tiefenerstreckung der p$^+$-Zone (3) 10 bis 100 % der Tiefenlage des pn$^+$-Überganges des Hauptemitters (2) beträgt.

4. Thyristor nach Anspruch 1 bis 3, dadurch gekennzeichnet, daß die Tiefe der p$^+$-Zone (3) 30 % der Tiefe des pn$^+$-Überganges des Hauptemitters (2) beträgt.

5. Thyristor nach Anspruch 1 bis 4, dadurch gekennzeichnet, daß die p$^+$-Zone (3) mindestens 0,1 $\mu$m in die Hauptemitterzone (2) eindringt.

6. Thyristor nach Anspruch 1 bis 5, dadurch gekennzeichnet, daß die Konzentration der Störstellen in der p$^+$-Zone (3) mindestens eine Größenordnung höher als in der p-Basis-Zone (6) ist und höchstens eine Größenordnung niedriger als in der Zone des n$^+$-leitenden Hauptemitters (2) ist.

7. Thyristor nach Anspruch 1 bis 6, dadurch gekennzeichnet, daß bei einer Dotierung der p-Basis-Zone (6) mit Gallium die p$^+$-Zone (3) mit Bor als Störstellenmaterial dotiert ist.

8. Thyristor nach Anspruch 1 bis 7, dadurch gekennzeichnet, daß sich die p$^+$-Zone (3) bis unter die Elektrode (7) des Hilfsemitters (1) erstreckt.

9. Verfahren zum Herstellen eines Thyristors mit Amplifying Gate nach einem der Ansprüche 1 bis 8, nach welchem Verfahren in einem Halbleiterkörper aus Silizium die Zonenstruktur eines Thyristors ausgebildet wird, dadurch gekennzeichnet, daß bei einem mit der Zonenstruktur eines Thyristors (1, 2, 6, 8, 9) ausgebildeten Halbleiterkörper das dem Hilfsemitter (1) zugewandte Randgebiet des Hauptemitters (2) mit einer Diffusionsmaske maskiert wird und alsdann ein Akzeptorelement so lange in den Halbleiterkörper eindiffundiert wird, bis die Störstellen-Konzentration in der sich bildenden p$^+$-Zone (3) höchstens eine Größenordnung geringer als die Konzentration der Donatoren in der n$^+$-Zone (2) wird und ein p$^+$n$^+$-Übergang mit dem Hauptemitter (2) gebildet ist.

9. A method for producing a thyristor with amplifying gate according to one of claims 1 to 8, in which method the zone structure of a thyristor is produced in a silicon semiconductor body, characterised in that, on semiconductor body having the zone structure of a thyristor (1, 2, 6, 8, 9), the edge region of the main emitter (2) facing the secondary emitter (1) is masked with a diffusion mask, and an acceptor element is then diffused into the semiconductor body long enough for the impurity concentration in the p$^+$-zone formed is at most an order of magnitude less than the donor concentration in the n$^+$-region (2) and a p$^+$n$^+$-junction is formed with the main emitter (2).

## Claims

1. A thyristor with amplifying gate, having a silicon semi-conductor body, which on the cathode side of the principal plane has n$^+$-conductive main and secondary emitters, main and secondary electrodes, and a control electrode, together with a p$^+$-region (3) lying between the main and secondary emitters (2, 1) within the p-base region (6) bordering the principal plane of the semi-conductor body, characterised in that the depth of the p$^+$-region (3) in the p-base region is less than that of the main emitter zone (2), and the region (3) at least touches, or extends into, the edge region of the main emitter (2) facing the secondary emitter (1), forming with it a p$^+$n$^+$-junction.

2. A thyristor with amplifying gate according to claim 1, characterised in that the p$^+$-region (3) contacts, or extends into, the entire edge region of the main emitter (2) facing the secondary emitter (1), forming with it a p$^+$n$^+$-junction.

3. A thyristor according to claim 1 or 2, characterised in that the depth of the p$^+$-region (3) is equal to 10 to 100 percent of the depth of the pn$^+$-junction of the main emitter (2).

4. A thyristor according to claims 1 to 3, characterised in that the depth of the p$^+$-region (3) is equal to 30 percent of the depth of the pn$^+$-junction of the main emitter (2).

5. A thyristor according to claims 1 to 4, characterised in that the p$^+$-region (3) extends at least 0.1 into the main emitter zone (2).

6. A thyristor according to claims 1 to 5, characterised in that the concentration of impurities in the p$^+$-region (3) is at least an order of magnitude greater than in the p-base-region (6), and at the most an order of magnitude less than in the region of the n$^+$-conductive main emitter (2).

7. A thyristor according to claims 1 to 6, characterised in that the p-basis region (6) is doped with gallium, and the p$^+$-region (3) is doped with boron as impurity material.

8. A thyristor according to claims 1 to 7, characterised in that the p$^+$-region (3) extends to below the electrode (7) of the secondary emitter (1).

## Revendications

1. Thyristor à gâchette amplificatrice, comportant un substrat semiconducteur en silicium, dont la face principale située du côté de la cathode comprend un émetteur principal et un émetteur auxiliaire, de type n$^+$ avec une électrode principale et une électrode auxiliaire, et une gâchette, ainsi qu'une région p$^+$ (3) située entre l'émetteur auxiliaire (1) et l'émetteur principal (2), dans une zone de la région de base p (6) adjacente à la face principale du substrat semiconducteur, ledit thyristor étant caractérisé en ce que l'épaisseur de la région p$^+$ (3) dans la région de base p (6) est inférieure à celle de la région de l'émetteur principal (2) ; et la région p$^+$ (3) est au moins en contact avec ou pénètre dans la zone limite de l'émetteur principal (2) située en regard de l'émetteur auxiliaire (1), avec laquelle elle forme une jonction p$^+$n$^+$.

2. Thyristor à gâchette amplificatrice selon revendication 1, caractérisé en ce que la région p$^+$ (3) est en contact avec ou pénètre dans l'ensemble de la zone limite de l'émetteur principal (2) située en regard de l'émetteur auxiliaire (1), avec laquelle elle forme une jonction p$^+$n$^+$.

3. Thyristor selon une des revendications 1 ou 2, caractérisé en ce que l'épaisseur de la région p$^+$ (3) représente 10 à 100 % de la profondeur de la jonction pn$^+$ de l'émetteur principal (2).

4. Thyristor selon revendication 1 à 3, caractérisé en ce que l'épaisseur de la région p$^+$ (3) est égale à 30 % de la profondeur de la jonction pn$^+$ de l'émetteur (2).

5. Thyristor selon revendications 1 à 4, caractérisé en ce que la région p$^+$ (3) pénètre d'au moins 0,1 μm dans la région de l'émetteur principal (2).

6. Thyristor selon revendications 1 à 5, caractérisé en ce que la concentration en impuretés de la région p$^+$ (3) est supérieure d'un ordre de grandeur au moins à celle de la région de base p (6) et inférieure d'un ordre de grandeur au plus à celle de la région de l'émetteur principal (2) de type n$^+$.

7. Thyristor selon revendications 1 à 6, caractérisé en ce que la région p$^+$ (3) est dopée avec du bore quand la région de base p (6) est dopée avec du gallium.

8. Thyristor selon revendications 1 à 7, caractérisé en ce que la région p⁺ (3) s'étend jusque sous l'électrode (7) de l'émetteur auxiliaire (1).

9. Procédé de production d'un thyristor à gâchette amplificatrice selon une quelconque des revendications 1 à 8, avec réalisation de la structure de régions d'un thyristor dans un substrat semiconducteur en silicium, ledit procédé étant caractérisé en ce que dans un substrat semiconducteur réalisé avec la structure de régions d'un thyristor (1, 2, 6, 8, 9), la zone limite de l'émetteur principal (2) située en regard de l'émetteur auxiliaire (1) est recouverte d'un masque de diffusion, puis un élément accepteur est diffusé dans le substrat semiconducteur jusqu'à ce que la concentration en impuretés de la région $p^+$ ('') en formation soit inférieure d'un ordre de grandeur au maximum à la concentration en donneurs de la région $n^+$ (2) et qu'une jonction $p^+n^+$ soit formée avec l'émetteur principal (2).

0 007 099

FIG.1

FIG.2

FIG.3

FIG.4

FIG.5

# FIG.6

n+     p+     n+    n+    n+

# FIG.7

# FIG.8

# FIG.9

# FIG.10

# FIG.11

0 007 099